(19) **Europäisches Patentamt / European Patent Office / Office européen des brevets**

(11) **EP 4 445 493 B1**

(12) **EUROPÄISCHE PATENTSCHRIFT**

(45) Veröffentlichungstag und Bekanntmachung des Hinweises auf die Patenterteilung:
**29.10.2025   Patentblatt 2025/44**

(21) Anmeldenummer: **22834599.7**

(22) Anmeldetag: **09.12.2022**

(51) Internationale Patentklassifikation (IPC):
**H03B 17/00** *(2006.01)*

(52) Gemeinsame Patentklassifikation (CPC):
**H03B 17/00**

(86) Internationale Anmeldenummer:
**PCT/EP2022/085114**

(87) Internationale Veröffentlichungsnummer:
**WO 2023/105026 (15.06.2023 Gazette 2023/24)**

(54) **EINSTELLBARE SIGNALQUELLE MIT KLEINEM PHASENRAUSCHEN**

ADJUSTABLE SIGNAL SOURCE WITH LOW PHASE NOISE

SOURCE DE SIGNAUX RÉGLABLE À FAIBLE BRUIT DE PHASE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **10.12.2021   DE 102021214164**

(43) Veröffentlichungstag der Anmeldung:
**16.10.2024   Patentblatt 2024/42**

(73) Patentinhaber: **Universität Paderborn**
**33098 Paderborn (DE)**

(72) Erfinder:
• **BAHMANIAN, Meysam**
**44803 Bochum (DE)**
• **SCHEYTT, Johannes Christoph**
**46284 Dorsten (DE)**

(74) Vertreter: **RCD-Patent**
**Giesen, Schmelcher & Griebel**
**Patentanwälte PartG mbB**
**Postfach 3106**
**52118 Herzogenrath (DE)**

(56) Entgegenhaltungen:
**CN-B- 107 124 910**

• **BAHMANIAN MEYSAM ET AL: "Octave-Band Microwave Frequency Synthesizer Using Mode-Locked Laser as a Reference", 2019 INTERNATIONAL TOPICAL MEETING ON MICROWAVE PHOTONICS (MWP), IEEE, 7 October 2019 (2019-10-07), pages 1 - 4, XP033648657, DOI: 10.1109/MWP.2019.8892046**
• **HOU DONG ET AL: "Long-Term Stabilization of Fiber Laser Using Phase-Locking Technique With Ultra-Low Phase Noise and Phase Drift", IEEE JOURNAL OF SELECTED TOPICS IN QUANTUM ELECTRONICS, IEEE, USA, vol. 20, no. 5, 30 September 2014 (2014-09-30), pages 1 - 8, XP011549284, ISSN: 1077-260X, [retrieved on 20140528], DOI: 10.1109/JSTQE.2014.2316592**

**Beschreibung**

Für viele Bereiche der Elektrotechnik ist die Bereitstellung eines Signales mit geringem Phasenrauschen gewünscht. Besonders wünschenswert wäre es, wenn diese Signalquelle über einen großen Frequenzbereich mit hoher Frequenzauflösung einstellbar wäre.

Eine beispielhafte Verwendung wäre das Einrasten eines Mikrowellenoszillators auf ein optisches Taktsignal einer solchen Signalquelle. Eine andere Verwendung wäre die Verteilung eines optischen Taktsignales über eine verlustarme Faser mit geringem Phasenrauschen.

Aus dem Stand der Technik sind verschiedene Ansätze bekannt.

Beispielsweise ist aus dem Artikel "Subfemtosecond synchronization of microwave oscillators with mode-locked Er-fiber lasers," der Autoren Kwangyun Jung und Jungwon Kim, veröffentlicht in Optics Letters, vol. 37, no. 14, p. 2958, Jul 2012, https://doi.org/10.1364/OL.37.002958 eine Vorrichtung bekannt, die es erlaubt einen Mikrowellenoszillator auf ganzzahlige Harmonische der Wiederholrate eines optischen Taktgebers einzurasten.

Weiterhin ist ein symmetrischer optischer Mikrowellphasendetektor aus dem Artikel "A 2-20-GHz ultralow phase noise signal source using a microwave oscillator locked to a mode-locked laser," der Autoren und Erfinder M. Bahmanian und J. C. Scheytt, veröffentlicht in IEEE Transactions on Microw. Theory Tech. pp. 1-1 (2021), bekannt.

Ebenso ist es aus diesen Artikeln bekannt, dass hierzu ein Mikrowellenphasendetektor mit einem faserbasierten Sagnac-loop intensity Modulator oder einem Mach-Zehnder intensity Modulator verwendet werden kann.

Weiterhin ist aus dem Artikel "Octave-Band Microwave Frequency Synthesizer Using Mode-Locked Laser as a Reference" der Autoren Bahmanian, Tiedau, Silberhorn und Scheytt, veröffentlicht in 2019 International Topical Meeting on Microwave Photonics (MWP), 07-10 October 2019, Seiten 1-4. DOI: 10.1109/MWP.2019.8892046 ein Oktavenband-Spannungs-Oszillator bekannt, der phasen-gerastet auf der Einhüllenden eines Pulszuges eines Moden-gerasteten Lasers ist.

Allen bisher den Erfindern bekannten Ansätzen ist es gemeinsam, dass die gegenwärtigen Systemdesigns nur dazu in der Lage sind ein Hochfrequenzsignal bereitzustellen, das ein ganzzahliges Vielfaches der Wiederholrate der optischen Signalquelle aufweist. D.h. die Ausgangsfrequenz ergibt sich zu $f_{out} = N * f_{rep}$ mit $N \in \mathbb{N}$ .

Bei den bisher den Erfindern bekannten Ansätzen wird der symmetrische Modulator an seinem ungeraden Symmetriepunkt vorgespannt, d.h. eine Vorspannung an diesem Punkt führt dazu, dass die Intensitäten der optischen Ausgänge gleich sind. Dabei wechselt das Vorzeichen des Ausgangsstromes des symmetrischen optischen Mikrowellphasendetektors bei einer null-wertigen Phasendifferenz für alle hochfrequenten Amplituden.

Nachteilig an den bisher bekannten Ansätzen ist, dass diese nur dazu geeignet sind entweder eine genau bestimmte (fest-eingestellte) Frequenz bereitstellen zu können, oder aber, dass diese nur genau vorbestimmte ganzzahlige Vielfache erzeugen können.

Nachteilig ist weiterhin, dass einige der Aufbauten einen sehr komplexen Aufbau aufweisen. Andere Mängel sind z.B. ein verhältnismäßig hoher Platzbedarf, der insbesondere bei faserbasierten Sagnac-loop intensity Modulator gegeben ist und hohe Kosten.

Aufgabe

Vor diesem Hintergrund ist es eine Aufgabe der Erfindung, eine Verbesserung bereitzustellen. Insbesondre ist es dabei ein Ziel einen unkomplizierten, platzsparenden Aufbau zur Verfügung zu stellen. Ein weiteres Ziel ist es die Frequenzauflösung zu verbessern.

Kurzdarstellung der Erfindung

Die Aufgabe wird gelöst durch eine einstellbare Signalquelle mit kleinem Phasenrauschen gemäß Anspruch 1. Weitere vorteilhafte Ausgestaltungen der Erfindung sind Gegenstand der abhängigen Ansprüche, der Beschreibung und der Figuren.

Kurzdarstellung der Figuren

Nachfolgend wird die Erfindung näher unter Bezug auf die Figuren erläutert. In diesen zeigt:

Fig. 1a schematisch einen symmetrischen optischen Mikrowellphasendetektor gemäß Stand der Technik,

Fig. 1b schematisch ein Blockersatzschaltbild hierzu,

Fig. 2 schematisch einen symmetrischen optischen Mikrowellphasendetektor gemäß der Erfindung, und

Fig. 3a-d Graphen zu Messungen gemäß Ausführungsformen der Erfindung in Bezug zu theoretischen Werten.

Ausführliche Darstellung der Erfindung

Nachfolgend wird die Erfindung eingehender unter Bezugnahme auf die Figuren dargestellt werden. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden, soweit nicht explizit als reine Alternative dargestellt.

Weiterhin wird nachfolgend der Einfachheit halber in aller Regel immer nur auf eine Entität Bezug genommen. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

Soweit nachfolgend Verfahren beschrieben werden, sind die einzelnen Schritte eines Verfahrens in beliebiger Reihenfolge anordbar und/oder kombinierbar, soweit sich durch den Zusammenhang nicht explizit etwas Abweichendes ergibt. Weiterhin sind die Verfahren - soweit nicht ausdrücklich anderweitig gekennzeichnet - untereinander kombinierbar.

Angaben mit Zahlenwerten sind in aller Regel nicht als exakte Werte zu verstehen, sondern beinhalten auch eine Toleranz von +/- 1 % bis zu +/- 10 %.

Bezugnahme auf Standards oder Spezifikationen sind als Bezugnahme auf Standards bzw. Spezifikationen, die zum Zeitpunkt der Anmeldung und/oder - soweit eine Priorität beansprucht wird - zum Zeitpunkt der Prioritätsanmeldung gelten / galten zu verstehen. Hiermit ist jedoch kein genereller Ausschluss der Anwendbarkeit auf nachfolgende oder ersetzende Standards oder Spezifikationen zu verstehen.

Unter Bezug auf die Figuren wird nachfolgend eine Vorrichtung bzw. ein Verfahren erläutert.

Bevor die Erfindung im Detail erläutert werden wird, stellen wir nachfolgend zunächst den theoretischen Hintergrund des "Interharmonic Locking" dar.

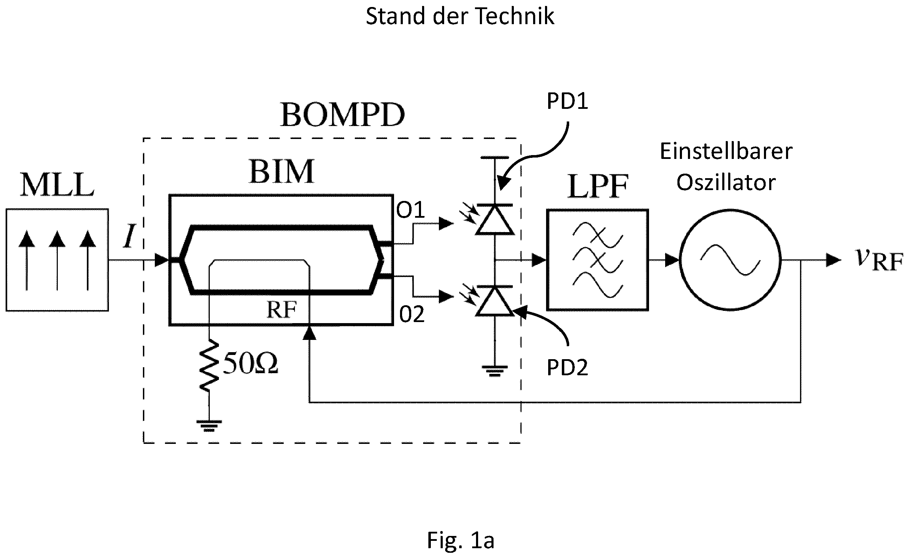

Aus Figur 1a ist ein Blockdiagramm einer optoelektronischen PLL-Schaltung zu sehen. Die Ausgangsspannung des einstellbaren Oszillators wird mit den Pulsen eines mode-locked Laser MLL abgetastet. Hierzu dient der Intensitätsmodulator BIM. Dieser Intensitätsmodulator BIM wird auch als symmetrischer Intensitätsmodulator (engl. balanced intensity modulator) bezeichnet und stellt einen elektro-optischen Wandler dar.

Die ausgehenden optischen Pulse aus dem Intensitätsmodulator BIM werden dabei in einen elektrischen Strom über die beiden Photodioden PD1, PD2 konvertiert. Der daraus resultierende Strom wird anschließend über den Schleifenfilter integriert und anschließend an den einstellbaren Oszillator zurückgeführt, sodass die Regelstrecke geschlossen ist.

Der Ausgangsstrom kann wie folgt dargestellt werden:

$$i = RI(t)\,sin\left(\frac{v_{RF}\pi}{V_{\pi,RF}} + \psi_{dc}\right),$$

wobei *i* der Ausgangsstrom des optischen Mikrowellenphasendetektor BOMPD, R die Empfindlichkeit der Photodiode ist, I(t) die über einen optischen Umlauf gemittelte Intensität des optischen Eingangs zu dem optischen Mikrowellenphasendetektor BOMPD, $\psi_{dc}$ die durch die dc Elektrode eingefügte optische Phasenverschiebung, $V_{\pi,RF}$ die $\pi$-Spannung der RF Elektrode und $v_{RF}$ die sinusförmige RF Modulationsspannung mit einer Amplitude von $V_{RF}$, einer Kreisfrequenz von $\omega_{RF}$ und einem Phasenoffset von $\phi$ ($v_{RF}$)= $V_{RF}$ sin ($\omega_{RF}t + \phi$) ist.

Der Sinusterm in der ersten Gleichung zeigt an, dass die RF Spannung einer nichtlinearen Transformation unterliegt, die Harmonische einer eintonalen RF Anregung erzeugt.

Folglich kann der optische Mikrowellenphasendetektor BOMPD als ein nichtlinearer Block und ein Frequenzmischer modelliert werden. Das nicht-lineare Verhalten des optischen Mikrowellenphasendetektors BOMPD kann nun dazu verwendet werden, um den Mikrowellenoszillator auf einer harmonischen einzurasten anstatt auf dem jeweiligen Grundton, d.h. auf einem geradzahligen Vielfachen der Wiederholrate der optischen Referenz.

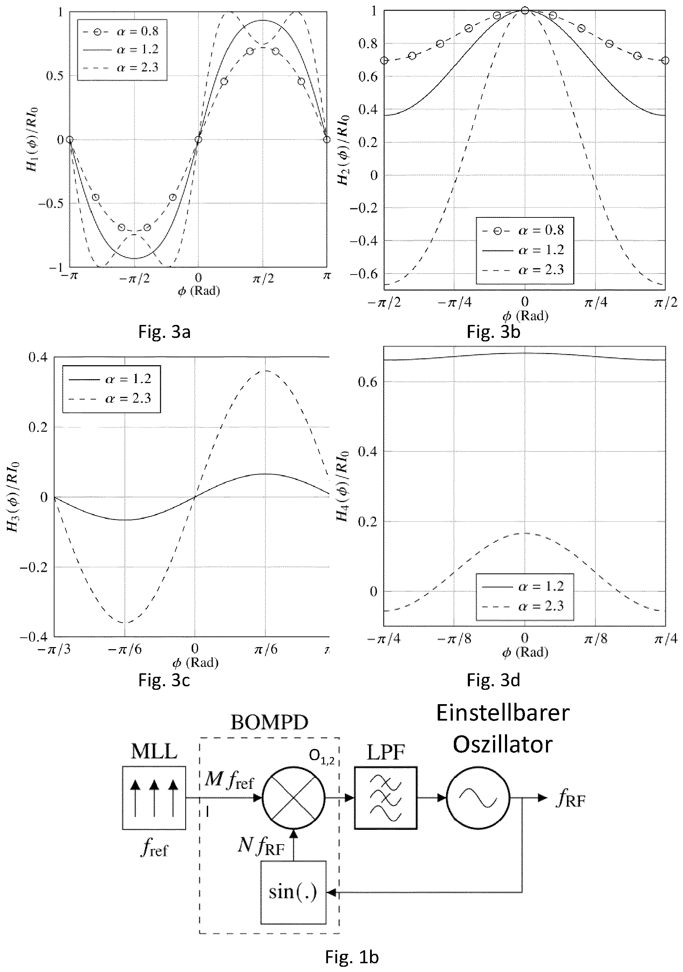

Der Frequenzinhalt der verschiedenen Knoten des optische Mikrowellenphasendetektors BOMPD ist in Figur 1b) dargestellt, wobei M der Harmonischenindex der Wiederholrate der optischen Referenz und N der Harmonischenindex der RF Spannung ist.

Die optoelektronischen PLL-Schaltung rastet ein, wenn die Frequenz der Mischereingänge die nachfolgende Gleichung erfüllt: $f_{RF} = \frac{M}{N}f_{ref}$, wobei M und N positive Ganzzahlen mit dem größten gemeinsamen Teiler 1 sind.

Nachfolgend wird der Betrieb der optoelektronischen PLL-Schaltung mit N=1 als harmonisches Einrasten und mit N>1 als interharmonisches Einrasten Nter Ordnung bezeichnet.

Unter der Annahme, dass optische Pulse des mode-locked Laser MLL erheblich kürzer sind als die RF Signalperiode, kann jeder Puls als eine Dirac Delta Funktion approximiert werden:

$$I(t) = I_0 T_{ref} \sum_{m=-\infty}^{+\infty} \delta\left(t - \frac{m}{f_{ref}}\right),$$

wobei $I_0$ die durchschnittlichen Intensität des optischen Eingangs und $T_{ref} = 1/f_{ref}$ ist.

Dann kann die Gleichung mit $\alpha = \pi V_{RF} / V_{\pi\,RF}$ wie folgt umgeschrieben werden:

$$i = R I_0 T_{ref} \sum_{m=-\infty}^{+\infty} \delta\left(t - \frac{m}{f_{ref}}\right) \sin[\alpha \sin(\omega_{RF} t + \phi) + \psi_{dc}].$$

Die charakteristische Funktion (Übertragungsfunktion) des Phasendetektors ist definiert als der durchschnittliche Ausgangsstrom in Bezug zu der Phasendifferenz zwischen den Eingängen Für die Phasendetektion des interharmonisches Einrastens Nter Ordnung weist der Ausgangsstrom der obigen Gleichung eine Periode von $NT_{ref}$ auf. Daher kann die charakteristische Funktion (Übertragungsfunktion) des optischen Mikrowellenphasendetektor BOMPD $H_N(\varphi)$ wie folgt angegeben werden:

$$H_N(\phi) = \frac{1}{NT_{ref}} \int_0^{NT_{ref}} dt\, i = \frac{RI_0}{N} \sum_{m=0}^{N-1} \sin\left[\alpha \sin\left(\frac{2\pi m}{N} + \phi\right) + \psi_{dc}\right],$$

wobei in dieser Gleichung der Index M unter der Annahme des größten gemeinsamen Vielfachen von M und N zu 1 vernachlässigt wurde.

Hieraus können die charakteristische Funktion (Übertragungsfunktion) des Phasendetektors BOMPD der 1., 2. und 4. Ordnung (entsprechend einem harmonischen Einrasten, interharmonischen Einrasten 2ter Ordnung, interharmonischen Einrasten 4ter Ordnung, entsprechender Weise) erstellt werden:

$$H_1(\phi) = RI_0 \sin(\alpha \sin(\phi) + \psi_{dc})$$

$$H_2(\phi) = RI_0 \sin(\psi_{dc}) \cos[\alpha \sin(\phi)]$$

$$H_4(\phi) = \frac{1}{2} RI_0 \sin(\psi_{dc}) \left[\cos(\alpha \sin\phi) + \cos(\alpha \cos\phi)\right]$$

Die zwei letzten Gleichungen $H_2(\phi)$ und $H_4(\phi)$ zeigen, dass die charakteristische Funktion (Übertragungsfunktion) des Phasendetektors BOMPD der 2. und 4. Ordnung linear mit $sin(\Psi_{dc})$ skalieren und zu Null werden, wenn $\Psi_{dc}=0$. Dieses Verhalten ist zu erwarten, da die am Anfang gezeigte nichtlineare charakteristische Funktion (Übertragungsfunktion) des Phasendetektors BOMPD eine gleich Symmetrie (Achsensymmetrie) in Bezug auf $v_{RF}$ bei $\Psi_{dc}=\pm\pi/2$ und eine ungleiche Symmetrie (Punktsymmetrie) bei $\Psi_{dc}=0$ aufweist.

Bei einer Einzeltonanregung werden nur ungerade Harmonische bei $\Psi_{dc}=0$ und nur gerade Harmonische bei $\Psi_{dc}==\pm\pi/2$ erzeugt.

Der Betrag von $H_N(\phi)$ kann unter Verwendung der Jacobi-Anger-Entwicklung wie folgt dargestellt werden:

$$\langle H_N(\phi)\rangle = RI_0 \sin(\psi_{dc}) J_0(\alpha),$$

wobei <.> den Durchschnittswert und $J_0$ die Besselfunktion erster Gattung und 0. Ordnung bezeichnet. Eine im Mittel Nullwertige $H_N(\phi)$ garantiert einen Nulldurchgang in der Übertragungsfunktion.

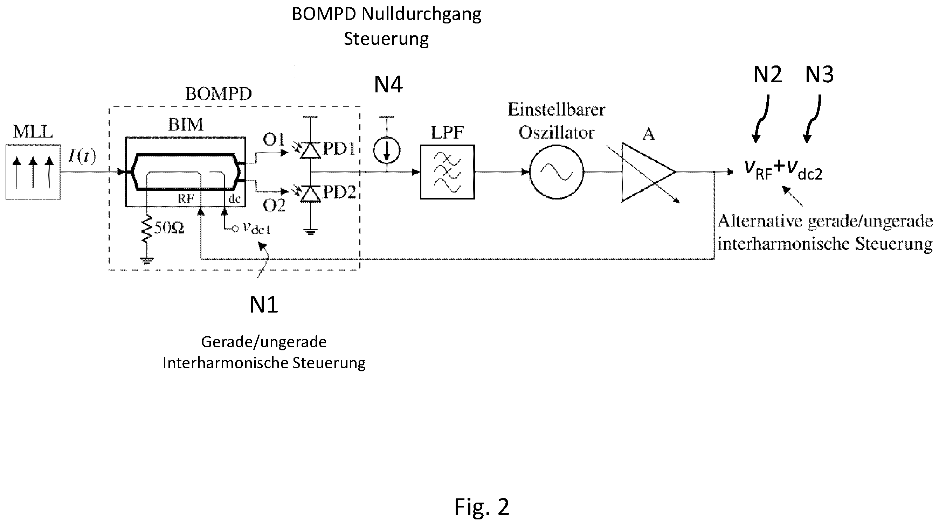

Nachfolgend wird an Hand der Figur 2 (und im Rückgriff auf den Stand der Technik gemäß Figur 1a) die Erfindung näher erläutert werden. Dabei werden - soweit als möglich -gleiche Referenzzeichen verwendet.

In Figur 2 ist eine einstellbare Signalquelle mit kleinem Phasenrauschen in einer Anwendung gezeigt. Die einstellbare Signalquelle weist einen optischen Mikrowellenphasendetektor BOMPD auf. Der Aufbau ist zunächst wie im Stand der Technik ("A 2-20-ghz ultralow phase noise signal source using a microwave oscillator locked to a mode-locked laser") bereitgestellt.

Dabei weist der Mikrowellenphasendetektor BOMPD zunächst einen Intensitätsmodulator BIM, mit einem optischen Signaleingang, einem Modulationseingang I, und einem ersten Ausgang O1 und einen zweiten Ausgang O2 auf. Der Intensitätsmodulator BIM in Fig. 1a/1b und Fig. 2 wird auch als symmetrischer Intensitätsmodulator (engl. balanced intensity modulator) bezeichnet und stellt einen elektro-optischen Wandler dar. Die Ausgestaltung des Intensitätsmodulator BIM kann unterschiedlich gestaltet sein.

Weiterhin weist der Mikrowellenphasendetektor BOMPD eine erste Photodiode PD1, die im Betrieb mit Licht des ersten Ausgangs O1 bestrahlt werden kann, und eine zweite Photodiode PD2, die im Betrieb mit Licht des zweiten Ausgangs O2 bestahlt werden kann, auf.

Im Unterschied zum Aufbau aus dem Stand der Technik wird nunmehr im Rahmen der Erfindung die erste Photodiode PD1 und die zweite Photodiode PD2, die in Reihe geschaltet sind, im Betrieb vorgespannt ist. Die Reihenschaltung ist so aufgebaut, dass zwischen der ersten Photodiode PD1 und der zweiten Photodiode PD2 ein Abgriff für ein Abgriffs-Signal angeordnet ist.

Weiterhin weist der Mikrowellenphasendetektor BOMPD eine steuerbare Gleichstromquelle (BOMPD Nulldurchgang Steuerung) N4 auf, wobei am Abgriff im Betrieb mittels der Gleichstromquelle ein Offsetstrom einstellbar ist, womit der Nulldurchgang der Übertragungsfunktion des BOMPD verändert wird und die Symmetrie des optischen Mikrowellenphasendetektor im Betrieb durch den Offsetstrom somit aufgehoben wird. D.h. anders als im Stand der Technik wird bewusst nicht der symmetrische Betrieb des BOMPD angestrebt.

Der Ausgang des Abgriffs wird im Betrieb mit einem eventuellen Offsetstrom an ein Tiefpassfilter geführt, wobei das tiefpassgefilterte Abgriffs-Signal einem einstellbaren Oszillator OSZ zur Verfügung gestellt wird.

Durch das Hinzufügen eines Offsetstromes mittels der steuerbaren Gleichstromquelle N4 (BOMPD Nulldurchgang Steuerung) wird es nunmehr ermöglicht, dass der Mikrowellenphasendetektor BOMPD auch auf nicht-geradzahligen Vielfachen der optischen Pulswiederholrate einrastet, um einen Vorzeichenwechsel des Ausgangsstromes des Mikrowellenphasendetektor BOMPD zu erreichen.

In einer Ausführungsform der Erfindung weist die einstellbare Signalquelle weiterhin eine steuerbare Gleichspannungsquelle N1 (gerade/ungerade interharmonische Steuerung) auf wobei der Intensitätsmodulator BIM einen Eingang für die Gleichspannungsquelle N1 aufweist.

Durch die Bereitstellung der Gleichspannungsquelle kann die Gleichspannungselektrode des Intensitätsmodultors BIM am Gleichpunkt der Symmetrie so vorspannen, dass es so ebenfalls ermöglicht wird, dass der Mikrowellenphasendetektor BOMPD auch auf nicht-geradzahligen Vielfachen der optischen Pulswiederholrate einrastet. Denn, falls ein symmetrischer Modulator an diesem Punkt vorgespannt wird, wird die Intensität einer der Ausgänge O1, O2 zum Maximum tendieren während gleichzeitig die Intensität des anderen Ausgangs O2, O1 dann zum Minimum tendiert. Daher kann dann die Ausgangsfrequenz zuverlässig auf $f_{out} = \frac{N \cdot f_{rep}}{M}$ mit $N$, $M \in \mathbb{N}$ eingestellt werden.

Gemäß einer weiteren Ausgestaltung der Erfindung weist die einstellbare Signalquelle eine steuerbare zweite Gleichspannungsquelle N2, N3 (alternative gerade/ungerade interharmonische Steuerung) auf, wobei im Betrieb dem Modulationseingang I rückgekoppelten Ausgangssignal des einstellbaren Oszillator OSZ zugeführt wird, wobei die Gleichspannung der zweiten Gleichspannungsquelle N2,N3 ebenfalls im Betrieb dem Modulationseingang I zugeführt wird.

Die Funktion der steuerbaren zweiten Gleichspannungsquelle (alternative gerade/ungerade interharmonische Steuerung) N2,N3 besteht darin, dass der DC-Anteil, d.h. der mittlere Pegel, des Signals des Oszillators OSZ einstellbar ist. Dies kann z.B. über einer Addition einer DC-Spannung zum Signal des Oszillators OSZ erreicht werden.

Eine Änderung der Gleichspannung der Hochfrequenzelektrode des Intensitätsmodultors BIM kann dazu genutzt werden, dass der Intensitätsmodultors BIM auf der Frequenz $f_{out} = \frac{N \cdot f_{rep}}{M}$ einrastet und so den Vorzeichenwechsel des Ausgangsstromes des optischen Mikrowellenphasendetektor BOPMD bei einem bestimmten Phasenoffset erzielt. Weiterhin kann die Gleichspannung der Hochfrequenzelektrode des Intensitätsmodultors BIM am Punkt, an dem die Kennlinie spiegelsymmetrisch ist, vorgespannt werden und auf einen nicht-geradzahligen Vielfachen der optischen Pulswiederholrate eigenrastet werden. Wiederum, falls ein symmetrischer Modulator an diesem Punkt vorgespannt wird, wird die Intensität einer der Ausgänge O1, O2 zum Maximum tendieren während gleichzeitig die Intensität des anderen Ausgangs O2, O1 dann zum Minimum tendiert.

In einer weiteren Ausgestaltung der Erfindung weist die einstellbare Signalquelle weiterhin einen mode-locked Laser MLL auf, der im Betrieb ein optisches Eingangssignal an den optischen Signaleingang zur Verfügung stellt.

In einer weiteren Ausgestaltung der Erfindung ist der Oszillator OSZ auf nicht-ganzzahlige Vielfache der optischen Taktwiederholzeit einstellbar. D.h., zusätzlich zu der Variante, dass nur eine bestimmtes nicht-geradzahliges Vielfaches bereitgestellt werden kann, kann auch ein wählbares Vielfaches eingestellt werden.

Im Rahmen der Erfindung wird es nunmehr auch ermöglicht, dass auch ein faser-basierter faserbasierten Sagnac-loop intensity Modulator BIM zum Einsatz kommt. Allerdings wird dieser nunmehr mit einer Phasenverschiebung betrieben, um ihn am geraden Symmetriepunkt entsprechend vorzuspannen.

Die Erfindung führt dazu, dass nunmehr mit geringer Komplexität ein kompaktes Design mit geringem Phasenrauschen ermöglicht wird. Zudem wird die Frequenzauflösung verbessert, sodass auch Vielfache mit $f_{out} = \frac{N \cdot f_{rep}}{M}$

mit $N$, $M \in \mathbb{N}$ eingestellt werden können. Zudem wird im Unterschied zu rein elektronischen Signalquellen das Phasenrauschen verbessert, d.h. verringert.

Ohne Beschränkung der Allgemeinheit kann auch noch ein optionaler Verstärker A im Rückkoppelzweig angeordnet sein.

Aus Figur 3 a-d sind charakteristische Kurven gemäß der Theorie bekannt.

Dabei zeigen die Figuren 3a-3d BOMPD charakteristische Kurven gemäß der Theorie (gepunktet) und gemäß Messungen für

a) harmonisches Einrasten bei $\psi_{dc} = 0$,
b) interharmonisches Einrasten zweiter Ordnung bei $\psi_{dc} = \pi/2$,
c) interharmonisches Einrasten dritter Ordnung bei $\psi_{dc} = 0$ und
d) interharmonisches Einrasten vierter Ordnung bei $\psi_{dc} = \pi/2$

für unterschiedliche RF Amplituden mit $\alpha = 0.8$, $\alpha = 1.2$ bzw. $\alpha = 2.3$.

Mit dem einstellbaren Verstärker A kann die Amplitude des Oszillatorsignals eingestellt werden, was zur Veränderung des Faktors $\alpha$ führt. Wie man an den charakteristischen Kurven in Fig. 3a-3d sieht, sind die charakteristischen Kurven von $\alpha$ abhängig. Wie man des Weiteren sieht, weisen nicht alle Kurven einen Nulldurchgang auf. Wenn nun die charakteristische Kurve keinen Nulldurchgang aufweist, kann die Regelschleife nicht einrasten. Dies bedeutet, dass durch die geeignete Einstellung der Oszillatoramplitude $V_{RF}$ der Faktor $\alpha$ so eingestellt werden kann, dass die charakteristische Kurve einen Nulldurchgang aufweist, und somit ein interharmonisches Einrasten möglich ist.

Referenzzeichenliste

| | |
|---|---|
| BOPMD | optischen Mikrowellenphasendetektor |
| BIM | Intensitätsmodulator |
| I | Modulationseingang |
| O1, O2 | Ausgang |
| PD1, PD2 | Photodiode |
| N4 | steuerbare Gleichstromquelle |
| OSZ | einstellbarer Oszillator |
| N1, N2, N3 | steuerbare Gleichspannungsquelle |
| MLL | mode-locked Laser |
| A | einstellbarer Verstärker |

**Patentansprüche**

1. Einstellbare Signalquelle mit kleinem Phasenrauschen, aufweisend

• einen optischen Mikrowellenphasendetektor (BOMPD) aufweisend

• einen Intensitätsmodulator (BIM), mit einem optischen Signaleingang, einem Modulationseingang (I), und einem ersten Ausgang (O1) und einen zweiten Ausgang (O2),
• eine erste Photodiode (PD1), die im Betrieb mit Licht des ersten Ausgangs (O1) bestrahlt werden kann,
• eine zweite Photodiode (PD2), die im Betrieb mit Licht des zweiten Ausgangs (O2) bestahlt werden kann,
• wobei die erste Photodiode (PD1) und die zweite Photodiode (PD2), im Betrieb vorgespannt in Reihe geschaltet sind,
• wobei zwischen der ersten Photodiode (PD1) und der zweiten Photodiode (PD2) ein Abgriff für ein Abgriffs-Signal angeordnet ist,

• wobei der Abgriff mit einem eventuellen Offsetstrom an ein Tiefpassfilter geführt wird,
• wobei das tiefpassgefilterte Abgriffs-Signal einem einstellbaren Oszillator (OSZ) zur Verfügung gestellt wird, **dadurch gekennzeichnet, dass** die einstellbare Signalquelle eine steuerbare Gleichstromquelle (N4) aufweist,
· wobei am Abgriff im Betrieb mittels der ersten Gleichstromquelle (N4) der eventuelle Offsetstrom einstellbar ist, womit die Symmetrie des optischen Mikrowellenphasendetektor im Betrieb durch den eventuellen Offsetstrom aufgehoben wird.

2. Einstellbare Signalquelle nach Anspruch 1, weiterhin aufweisend eine steuerbare Gleichspannungsquelle (N1), wobei der Intensitätsmodulator (BIM) einen Eingang für die zweite Gleichspannungsquelle (N1) aufweist.

3. Einstellbare Signalquelle nach Anspruch 1 oder 2, weiterhin aufweisend eine steuerbare zweite Gleichspannungsquelle (N3), wobei im Betrieb dem Modulationseingang (I) das Ausgangssignal des einstellbaren Oszillator (OSZ) rückkoppelnd zugeführt wird, wobei die Gleichspannung der zweiten Gleichspannungsquelle (N3) ebenfalls im Betrieb dem Modulationseingang (I) zugeführt wird.

4. Einstellbare Signalquelle nach einem der vorhergehenden Ansprüche, weiterhin aufweisend einen Verstärker (A). wobei der Verstärker (A) dazu eingerichtet ist, die Oszillatoramplitude ($V_{RF}$) derart einzustellen, dass ein interharmonisches Einrasten ermöglicht wird.

5. Einstellbare Signalquelle nach einem der vorhergehenden Ansprüche, weiterhin aufweisend einen mode-locked Laser (MLL), der im Betrieb ein optisches Eingangssignal an den optischen Signaleingang zur Verfügung stellt.

6. Einstellbare Signalquelle nach einem der vorhergehenden Ansprüche, **dadurch gekennzeichnet, dass** der Oszillator (OSZ) auf nicht-ganzzahlige Vielfache eine optischen Taktwiederholzeit einstellbar ist.

**Claims**

1. An adjustable signal source with low phase noise, comprising:

    • an optical-microwave phase detector (BOMPD), comprising:

        ◦ an intensity modulator (BIM) having an optical signal input, a modulation input (I), a first output (O1), and a second output (O2),
        ◦ a first photodiode (PD1) which can be irradiated by light from the first output (O1) during operation,
        ◦ a second photodiode (PD2) which can be irradiated by light from the second output (O2) during operation,
        ◦ wherein the first photodiode (PD1) and the second photodiode (PD2) are connected in series in a biased manner during operation,
        ◦ wherein a tap for a tap signal is arranged between the first photodiode (PD1) and the second photodiode (PD2),

    • whereby the tap is routed to the low-pass filter with any potential offset current,
    • whereby the low-pass-filtered tap signal is provided to an adjustable oscillator (OSZ) **characterized in that** the adjustable signal source comprises a controllable Direct Current source (N4)

    whereby at the tap the potential offset current may be adjusted by the first Direct Current source (N4), whereby the symmetry of the optical-microwave phase detector is canceled by the potential offset current) during operation.

2. The adjustable signal source according to claim 1, further comprising a controllable DC voltage source (N1), wherein the intensity modulator (BIM) comprises an input for the second DC voltage source (N1).

3. The adjustable signal source according to claim 1 or 2, further comprising a second controllable DC voltage source (N3), wherein the feedback output signal from the adjustable oscillator (OSZ) is supplied to the modulation input (I) during operation, wherein the DC voltage from the second DC voltage source (N2) is also supplied to the modulation input (I) during operation.

4. The adjustable signal source according to one of the preceding claims, further comprising an amplifier (A), wherein the amplifier (A) is configured to adjust the oscillator amplitude ($V_{RF}$) such that an interharmonic locking is enabled.

5. The adjustable signal source according to one of the preceding claims, further comprising a mode-locked laser (MLL), which provides an optical input signal to the optical signal input during operation.

6. The adjustable signal source according to one of the preceding claims, wherein the oscillator (OSZ) is set to non-integer multiples of the optical clock repetition time.

**Revendications**

1. Source de signal réglable avec un petit bruit de phase, comportant

• un détecteur de phase à microondes (BOMPD) comportant

• un modulateur d'intensité (BIM), avec une entrée de signal optique, une entrée de modulation (I) et une première sortie (O1) et une deuxième sortie (O2),
• une première photodiode (PD1), qui peut être irradiée en fonctionnement par la lumière de la première sortie (O1),
• une deuxième photodiode (PD2), qui peut être irradiée en fonctionnement par la lumière de la deuxième sortie (O2),
• sachant qu'en fonctionnement la première photodiode (PD1) et la deuxième photodiode (PD2) sont connectées polarisées en série,
• sachant qu'entre la première photodiode (PD1) et la deuxième photodiode (PD2) est disposée une prise pour un signal de prise,

• sachant que la prise est dirigée avec un courant de décalage éventuel sur un filtre passe-bas,
• sachant que le signal de prise passé au filtre passe-bas est mis à disposition d'un oscillateur réglable (OSZ), **caractérisé en ce que** la source de signal réglable comporte une source de courant à courant continu pilotable (N4),
sachant qu'en fonctionnement, le courant de décalage éventuel peut être réglé sur la prise au moyen de la première source de courant continu (N4), la symétrie du détecteur de phase à microondes optique étant en fonctionnement supprimée de ce fait par le courant de décalage éventuel.

2. Source de signal réglable selon la revendication 1, comportant en plus une source de tension continue pilotable (N1), sachant que le modulateur d'intensité (BIM) comporte une entrée pour la deuxième source de tension continue (N1).

3. Source de signal réglable selon la revendication 1 ou 2, comportant en plus une deuxième source de tension continue pilotable (N3), sachant qu'en fonctionnement, le signal de sortie de l'oscillateur réglable (OSZ) est acheminé en rétrocouplage à l'entrée de modulation (I), sachant que la tension continue de la deuxième source de tension continue (N3) est également acheminée en fonctionnement à l'entrée de modulation (I).

4. Source de signal réglable selon l'une quelconque des revendications précédentes, comportant en plus un amplificateur (A), sachant que l'amplificateur (A) est agencé pour régler l'amplitude d'oscillateur ($V_{RF}$) de telle manière qu'un enclenchement interharmonique est autorisé.

5. Source de signal réglable selon l'une quelconque des revendications précédentes, comportant en plus un laser à mode verrouillé (LMV/MLL) qui met à disposition en fonctionnement un signal d'entrée optique à l'entrée de signal optique.

6. Source de signal réglable selon l'une quelconque des revendications précédentes, **caractérisée en ce que** l'oscillateur (OSZ) peut être réglé sur un multiple à nombre non entier d'un temps de répétition de cycle optique.

Stand der Technik

Fig. 1a

EP 4 445 493 B1

Fig. 2

Fig. 3a

Fig. 3b

Fig. 3c

Fig. 3d

Fig. 1b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **KWANGYUN JUNG** ; **JUNGWON KIM**. Subfemtosecond synchronization of microwave oscillators with mode-locked Er-fiber lasers. *Optics Letters*, July 2012, vol. 37 (14), 2958, https://doi.org/10.1364/OL.37.002958
- **ERFINDER M. BAHMANIAN** ; **J. C. SCHEYTT**. A 2-20-GHz ultralow phase noise signal source using a microwave oscillator locked to a mode-locked laser. *IEEE Transactions on Microw. Theory Tech.*, 2021, 1-1

- **BAHMANIAN** ; **TIEDAU** ; **SILBERHORN** ; **SCHEYTT**. Octave-Band Microwave Frequency Synthesizer Using Mode-Locked Laser as a Reference. *2019 International Topical Meeting on Microwave Photonics (MWP), 07-10 October 2019*, 07 October 2019, 1-4